# EUROPÄISCHE PATENTSCHRIFT

(11) **EP 1 561 119 B1**
(45) Veröffentlichungstag und Bekanntmachung des Hinweises auf die Patenterteilung: **01.03.2006**
(21) Anmeldenummer: 03785642.4
(22) Anmeldetag: 12.11.2003
(51) Int. Cl.: G01R 19/155

(54) **VORRICHTUNG UND VERFAHREN ZUR BESTIMMUNG DER SPANNUNGSFREIHEIT VON MEHRPHASIGEN ELEKTRISCHEN LEITUNGEN**
DEVICE AND METHOD FOR DETERMINING THE ABSENCE OF APPLICATION OF STRESSES ON POLYPHASE ELECTRICAL TRANSMISSION LINES
DISPOSITIF ET PROCEDE POUR DETERMINER L'ABSENCE D'APPLICATION DE CONTRAINTES SUR DES LIGNES ELECTRIQUES POLYPHASEES

(30) Priorität: 12.11.2002 DE 10252869
(43) Veröffentlichungstag der Anmeldung: 10.08.2005
(73) Patentinhaber: Pfalzwerke Aktiengesellschaft, 67061 Ludwigshafen (DE)
(72) Erfinder: WERNER, Christian, 67251 Freinsheim (DE); RÖHRENBECK, Gerhard, 67229 Laumersheim (DE)
(74) Vertreter: Kesselhut, Wolf
(86) Internationale Anmeldenummer: PCT/EP2003/012642
(87) Internationale Veröffentlichungsnummer: WO 2004/044597

(56) Entgegenhaltungen:
- CH-A- 520 375
- US-A- 4 635 055
- US-A- 5 867 019

## Beschreibung

Die Erfindung betrifft eine Vorrichtung und ein Verfahren zur Bestimmung der Spannungsfreiheit oder Spannungsführung von ein- oder mehrphasigen elektrischen Leitungen, insbesondere von Kabelverbindungen mit Spannungen im Bereich von 1000 V.

Im Bereich der elektrischen Energietechnik ist es bei Arbeiten an Niederspannungskabeln oder Stromleitungen für die elektrische Energieversorgung von Anlagen oder Netzteilen erforderlich, dass diese Niederspannungskabel spannungsfrei geschaltet werden, da es aufgrund der Spannung von ca. 400 V im Falle eines Kurzschlusses aufgrund der hohen Kurzschlussleistung zu erheblichen Strömen kommt, die eine sehr große Gefahr für das Leben der Personen darstellen, welche derartige Arbeiten ausführen.

Hierbei ergibt sich in der Praxis das Problem, dass die Kabelverbindungen des Niederspannungsnetzes in der Regel mehrere verdrillte Phasen aufweisen, so dass bei Messungen mit bekannten Messeinrichtungen - insbesondere Zangenamperemetern, bei denen mit Hilfe einer um die Isolierung des Kabels herumgelegten Zange der Stromfluss innerhalb des Kabels anhand des mit dem Stromfluss verbundenen magnetischen Feldes bestimmt wird - die Messergebnisse je nach Phasenlage der verwendeten Wechselströme und Anordnung der Einzelphasen innerhalb des Kabels mit einer großen Unsicherheit behaftet sind.

Hierbei besteht beispielsweise die Gefahr, dass sich das gemessene Feld aller Ströme innerhalb des Kabels durch eine entsprechende Überlagerung der magnetischen Felder der Einzelphasen zu Null kompensiert, obwohl das Kabel von Strom durchflossen ist und unter Spannung steht.

Weiterhin stellt es ein großes Problem dar, dass sich mit den bekannten Zangenamperemetern lediglich die Stromfreiheit eines stromdurchflossenen Kabels bestimmen lässt, hingegen Kabel, die zwar unter elektrischer Spannung stehen, jedoch aufgrund eines fehlenden Verbrauchers nicht von einem Strom durchflossen sind, aufgrund des fehlenden Magnetfeldes mit einem Zangenamperemeter überhaupt nicht auf Spannungsfreiheit hin untersucht werden können.

Aus dem deutschen Gebrauchsmuster G 94 00 903 U1 ist eine Spannungsprüfungseinrichtung bekannt, welche eine Detektoreinheit mit einem Gehäuse 12 umfasst, an dessen vorderem stirnseitigen Ende eine spitzenartige Elektrode angeordnet ist, in der sich eine Antenneneinheit befindet, die dazu dient, ein in der Nähe der Spitze befindliches elektrisches Feld zu detektieren. Die Antenneneinheit gibt ihr Signal über einen Filter an einen Verstärker weiter, der das über eine Empfindlichkeits-Einstelleinheit in Hinblick auf einen vorteilhaften Arbeitsbereich einstellbare Signal an einen U/F-Wandler weiterleitet, der mit einem akustischen Signalgeber gekoppelt ist. Der akustische Signalgeber erzeugt beim Detektieren eines elektrischen Feldes, bzw. beim Vorhandensein einer Spannung ein vorgegebenes akustisches Signal, welches den Bediener des Gerätes vor der anliegenden Spannung warnt.

Außerdem zeigt CH 520 375 ein warngerät, das bei nicht ausreichender Spannung in einer elektrischen versorgungsleitung anspricht.

Aufgrund der starken Abhängigkeit der elektrischen Feldstärke vom Abstand zwischen Spitze und spannungsführender Phase sowie der Verwendung von lediglich einer einzigen Prüfspitze mit einer darin angeordneten Antenne, ergibt sich insbesondere bei mehradrigen oder mehrphasigen Leitungen mit sich einander überlagernden elektrischen Feldern und Strömen keine zuverlässige Bestimmung der Spannungsfreiheit einer zugehörigen Stromleitung.

Demgemäß ist es eine Aufgabe der vorliegenden Erfindung, eine Vorrichtung und ein Verfahren zu schaffen, mit denen sich die Spannungsfreiheit von stromlosen mehrphasigen elektrischen Leitungen, insbesondere von Starkstromleitungen mit Spannungen im Bereich von 400 V, mit sehr hoher Zuverlässigkeit bestimmen lässt.

Diese Aufgabe wird durch die Merkmale von Ansprüche 1, 18 und 19 gelöst.

Gemäß der Erfindung umfasst eine Vorrichtung zur Bestimmung der Spannungsfreiheit einer unter Spannung stehenden und mit einer Außenisolierung versehenen elektrischen Leitung mit einer, zwei oder mehr Phasen ein Gehäuse, in dem eine elektronische Mess- und Auswerteinrichtung sowie vorzugsweise eine mit der elektronischen Mess- und Auswerteinrichtung gekoppelte Anzeigeeinrichtung, beispielsweise ein LCD-Display oder auch eine akustische Anzeigeeinrichtung in Form eines Lautsprechers oder dergleichen, aufgenommen ist.

Sofern hierbei von einer Bestimmung der Spannungsfreiheit gesprochen wird, bedeutet dies, dass festgestellt wird, ob ein elektrisches Feld vorhanden ist oder nicht.

Am Gehäuse der erfindungsgemäßen Vorrichtung ist ein mit Messelektroden versehener Messkopf angeordnet, der vorzugsweise mit Hilfe einer geeigneten bekannten Steckverbindung lösbar mit dem Gehäuse verbunden ist.

Die Messelektroden des Messkopfes sind jeweils getrennt über zugeordnete elektrische Leitungen mit dem Eingang der elektronischen Mess- und Auswerteinrichtung verbunden, und stützen sich in erfindungsgemäßer Weise über federelastische Elemente, vorzugsweise über Spiralfedern oder Kunststoffzungen etc., am Gehäuse des Messkopfes ab.

Um die Spannungsfreiheit einer elektrischen Leitung zu bestimmen, wird der Messkopf mit den Messelektroden in der Weise an die Außenisolierung der elektrischen Leitung angelegt, dass die Messelektroden unter Auslenkung der federelastischen Elemente unter leichtem Druck an der Außenisolierung der elektrischen Leitung anliegen und hierbei mit einer federelastischen Kraft beaufschlagt werden.

Durch die erfindungsgemäße Vorrichtung ergibt sich der Vorteil, dass das elektrische Feld durch mindestens zwei Messelektroden erfasst wird, die in einem wohldefinierten Abstand vom Zentrum der elektrischen Leitung entfernt angeordnet sind, so dass beim Auftreten einer Potentialdifferenz zwischen mindestens jeweils zwei der Messelektroden oder gegenüber Erde, davon auszugehen ist, dass die elektrische Leitung unter Spannung steht.

Gemäß einer bevorzugten Ausführungsform der Erfindung wird das elektrische Feld hierbei mit Hilfe eines Erdspießes gegenüber dem Erdpotential bestimmt, wodurch sich eine erheblich höhere Genauigkeit bei der Spannungsmessung zwischen den Elektroden, und damit eine erheblich größere Sicherheit bei der Bestimmung der Spannungsfreiheit der elektrischen Leitung ergibt, da in vorteilhafter Weise immer gegenüber einem festen Bezugspotential gemessen wird.

Eine weitere Steigerung der Genauigkeit der Vorrichtung, und damit eine weitere Erhöhung der Sicherheit für die die Vorrichtung benutzenden Personen, lässt sich dadurch erzielen, dass die erfindungsgemäße Vorrichtung - oder genauer gesagt der Messkopf - nach dem Andrücken der Messelektroden an die Außenisolierung der elektrischen Leitung um eine im Wesentlichen entlang des Zentrums der Leitung verlaufende Achse rotiert wird und hierbei die zwischen den Messelektroden des Messkopfes auftretenden Potentialdifferenzen und/oder die bei einer Verwendung des Erdspießes relativ zum Erdpotential auftretenden Feldänderungen von der elektronischen Mess- und Auswerteinrichtung erfasst werden. Die Rotation des Messkopfes erfolg hierbei vorzugsweise in einer Ebene senkrecht zur Längsachse der elektrischen Leitung. Der Messkopf wird hierbei vorzugsweise rotationssymmetrisch zum Ausgangspunkt in die eine und in die andere Richtung rotiert.

Hierdurch ergibt sich gegenüber einer rein statischen Bestimmung der Spannungsfreiheit insbesondere bei mehrphasigen elektrischen Leitungen der Vorteil, dass eine an zwei oder mehreren der spannungsführenden Phasen der elektrischen Leitung anliegende Spannung selbst dann detektiert wird, wenn sich die elektrischen Felder der jeweiligen Phasen an den Messpunkten der Außenisolierung, an denen die Messelektroden anliegen, zufällig gegenseitig aufheben, was im statischen Falle eine Spannungsfreiheit signalisieren würde.

Durch das erfindungsgemäße Drehen des gesamten Messkopfes mit den daran aufgenommenen Elektroden um die Längsachse der elektrischen Leitung wird sichergestellt, dass zumindest zwei der Messelektroden des Messkopfes an einer anderen Position relativ zu den spannungsführenden Phasen positioniert werden, was beim Anlegen einer Spannung an beiden Phasen aufgrund der Überlagerung der elektrischen Einzelfelder in vorteilhafter Weise zwangsweise zum Auftreten einer Potentialdifferenz zwischen den beiden Messelektroden - und damit zu einem Spannungssignal - führt.

Gemäß einer weiteren Ausführungsform der Erfindung ist der Messkopf teilringförmig ausgebildet, wobei die Elektroden, beispielsweise zwei, drei, vier oder mehr Elektroden, an den jeweiligen zugehörigen federelastischen Elementen entlang der Innenumfangsfläche des Messkopfes angeordnet sind.

Der Teilring kann hierbei in vorteilhafter Weise als ein Halbring ausgebildet sein, der sich über einen Winkel von vorzugsweise 180° um den Umfang der Außenisolierung der elektrischen Leitung herum erstreckt.

Durch diese Ausgestaltung des Messkopfes ergibt sich der Vorteil, dass dieser unmittelbar auf den Umfang der elektrischen Leitung aufgesetzt werden kann, und für den Benutzer umgehend ersichtlich ist, dass die Elektroden an der Umfangsoberfläche der Außenisolierung anliegen.

Zudem ist ebenfalls ein einfacher Austausch des Messkopfes gegen einen anderen Messkopf mit größerem oder kleinerem Durchmesser möglich, wenn die Spannungsfreiheit einer mehrphasigen elektrischen Leitung mit größerem oder kleinerem Durchmesser bestimmt werden soll.

Gemäß einer weiteren Ausgestaltung der erfindungsgemäßen Vorrichtung kann der Messkopf in gleicher Weise kreisringförmig ausgebildet sein, wobei die Elektroden mit den federelastischen Elementen vorzugsweise radial zum Zentrum des Messkopfes hin weisend entlang der Innenumfangsfläche des Messkopfes angeordnet sind.

Hierbei weist der Messkopf vorzugsweise zwei oder auch mehrere Teilsegmente oder Teilelemente auf, die aus einer ersten geschlossenen Stellung, in der die Teilsegmente den Umfang der elektrischen Leistung im Wesentlichen vollständig umschließen, in eine zweite Stellung bewegbar sind, in der die beiden Teilelemente auseinandergefahren sind, und demgemäß der Messkopf auf die elektrische Leitung aufgesetzt werden kann. Die Teilsegmente bestehen vorzugsweise aus Isolatormaterial, beispielsweise aus Kunststoff, und sind vorzugsweise durch ein Scharnier aufklappbar miteinander verbunden; können jedoch in gleicher Weise auch die Form einer in Längsrichtung getrennten Hülse aus Isolatormaterial aufweisen, deren beide Hälften geringfügig versetzt zueinander angeordnet und ineinander verschiebbar sind.

Das Öffnen und Schließen der beiden Teilsegmente kann in diesem Falle z.B. über isolierte Betätigungshebel oder dergleichen erfolgen, die an den Teilelementen angreifen oder an diesen geformt sind.

Durch diese Ausführungsform der Erfindung ergibt sich der Vorteil, dass die gesamte mehrphasige elektrische Leitung vom Messkopf umschlossen ist, wodurch insbesondere bei einer Drehung des Messkopfes um die Längsachse der Leitung eine in höchstem Maße zuverlässige Messung durchgeführt werden kann.

Bei dieser Ausführungsform der Erfindung ergibt sich der weitere Vorteil, dass der Messkopf auf einfache Weise durch Ummanteln mit einer elektrisch leitenden Abschirmung, beispielsweise mit Metallblech, zuverlässig gegen elektrische Störsignale abgeschirmt werden kann, die beispielsweise von externen Quellen her in den Messkopf eingestreut werden, und dort wiederum Spannungen oder elektrische Felder induzieren, die zu einer Verfälschung des Messergebnisses führen können.

Die Messelektroden sind vorzugsweise kugel- oder kegelförmig ausgestaltet, und zur Erleichterung der Drehbewegung des Messkopfes um die zentrale Längsachse der elektrischen Leitung vorzugsweise drehbar an den federelastischen Elementen aufgenommen, wodurch sich der Vorteil ergibt, dass der Messkopf mit hoher Präzision und hoher Gleichmäßigkeit ohne großen Kraftaufwand auf einer vorgegebenen Bahn um die Umfangsoberfläche der Außenisolierung herumgeführt werden kann. Hierdurch können Sprünge in der elektrischen Feldstärke, die durch das Anliegen einer elektrischen Spannung an einer oder mehrer der Phasen der elektrischen Leitung hervorgerufen werden, durch die elektronische Mess- und Auswerteinrichtung leichter erfasst werden.

Gemäß einer weiteren Ausführungsform der Erfindung sind die Messelektroden als Kegel ausgebildet, die mit ihrem erweiterten Ende unmittelbar an den federelastischen Elementen befestigt sind, und die mit ihrer Spitze unmittelbar an der Umfangsoberfläche der Außenisolierung anliegen. Durch den Einsatz von kegelförmigen Messelektroden ergibt sich der Vorteil, dass die gemessenen Feldstärken zwischen Kegelspitze und einer oder mehrerer der Phasen in Folge des kleineren Krümmungsradius der Kegelspitze in vorteilhafter Weise erhöht sind, wodurch sich eine erhöhte Amplitude des von der elektronischen Mess- und Auswerteinrichtung an der zugehörigen Messelektrode gemessenen Signals ergibt.

Der Messkopf weist bei der bevorzugten Ausführungsform der Erfindung eine ungerade Anzahl von Messelektroden auf, die bei einem ringförmigen Messkopf beispielsweise fünf Elektroden betragen kann, und die bei einem halbringförmig ausgestalteten Messkopf vorzugsweise drei Elektroden umfasst, welche vorzugsweise in gleichmäßigen Abständen zueinander angeordnet sind. Hierdurch ergibt sich der Vorteil, dass bei einer minimalen Anzahl von Elektroden die Gefahr eines Auftretens von Stellungen des Messkopfes, an denen sich die elektrischen Felder der einzelnen Phasen zu Null oder einem sehr kleinen, nicht mehr messbaren Wert überlagern, erheblich reduziert ist.

In gleicher Weise besteht jedoch ebenfalls die Möglichkeit, dass der Messkopf eine gerade Anzahl von Messelektroden aufweist, z.B. 2, 4 oder 6 Elektroden, die in ungleichmäßigen Abständen zueinander im Messkopf angeordnet sind.

Die Erfindung wird nachfolgend mit Bezug auf die Zeichnungen anhand von bevorzugten Ausführungsformen beschrieben.

In den Zeichnungen zeigen:
- Fig. 1: Eine schematische Darstellung einer erfindungsgemäßen Vorrichtung mit einem kreisringförmig ausgebildeten Messkopf, der ein schematisch dargestelltes Starkstromkabel umschließt,
- Fig. 2: eine Querschnittsansicht eines Messkopfes mit einem in dessen Innenraum aufgenommenen Kabel gemäß einer weiteren Ausführungsform der Erfindung, bei der der Messkopf mit einer umfänglichen Abschirmung gegen externe Störsignale versehen ist,
- Fig. 3: eine schematische Blockdarstellung der elektronischen Mess- und Auswerteinrichtung sowie der daran angeschlossenen Messelektroden bei der Bestimmung der Spannungsfreiheit eines schematisch dargestellten Starkstromkabels mit drei elektrischen Phasen und einem Nullleiter,
- Fig. 4a-c: verschiedene Ausgestaltungen von Messköpfen, die abnehmbar am Gehäuse der erfindungsgemäßen Vorrichtung befestigt werden können,
- Fig.5a: eine Teildarstellung eines erfindungsgemäßen Messkopfes, bei dem die Messelektroden kegelförmig ausgebildet sind,
- Fig. 5b: eine schematische Teildarstellung eines erfindungsgemäßen Messkopfes, bei dem die Messelektroden rollenförmig oder kugelförmig ausgestaltet sind,
- Fig. 6: eine schematische Darstellung einer erfindungsgemäßen Vorrichtung mit einem kreisringförmig ausgebildeten Messkopf mit fünf Messelektroden, die in einer ersten Position an eine mehrphasige elektrische Leitung angelegt ist, und
- Fig. 7: eine weitere schematische Darstellung einer erfindungsgemäßen Vorrichtung mit einem halbringförmig ausgestalteten Messkopf mit drei Elektroden, welcher in einer zweiten, gegenüber Fig. 6 um 45° verdrehten Position an eine dreiphasige elektrische Leitung angelegt ist, zur Verdeutlichung des erfindungsgemäßen Verfahrens.

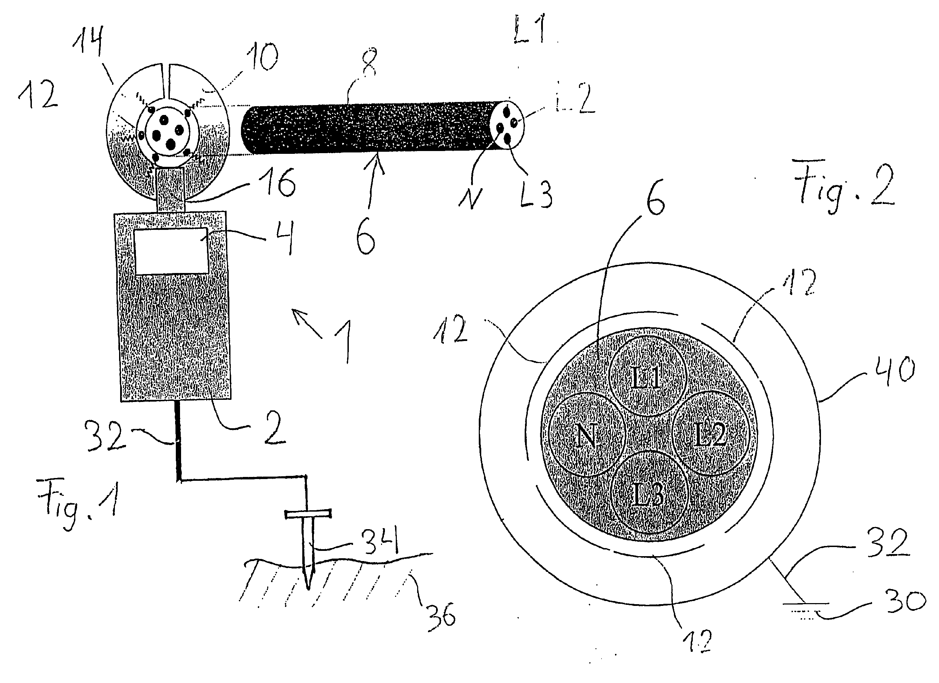

Wie in Fig. 1 gezeigt ist, umfasst eine erfindungsgemäße Vorrichtung 1 ein Gehäuse 2, in welchem eine Anzeigeeinrichtung 4 zur Anzeige der Spannungsfreiheit einer elektrischen Leitung 6 aufgenommen ist. Die Leitung 6 ist mit einer Außenisolierung 8 ummantelt, und enthält drei Phasen L1, L2 und L3 sowie einen Neutralleiter N. Die Leitung 6 kann beispielsweise eine Drehstromleitung mit einem Querschnitt zwischen 10 mm² und 150 mm² oder auch kleiner, z.B. 1,5 mm², sein, die im Erdreich verlegt ist und zur Übertragung von Drehstrom mit einer Wechselspannung von 400 V bei 50 Hz dient.

Wie der Darstellung von Fig. 1 weiterhin entnommen werden kann, ist am Gehäuse 2 ein Messkopf 10 angeordnet, der bei der Ausführungsform von Fig. 1 kreisringförmig ausgestaltet ist, und insgesamt fünf radial zum Zentrum des Kreisrings hin weisende Elektroden 12 besitzt, die durch federelastische Elemente 14 bei angelegtem Messkopf 10 gegen die Außenisolierung 8 der elektrischen Leitung 6 gedrückt werden, so dass sie an dieser anliegen.

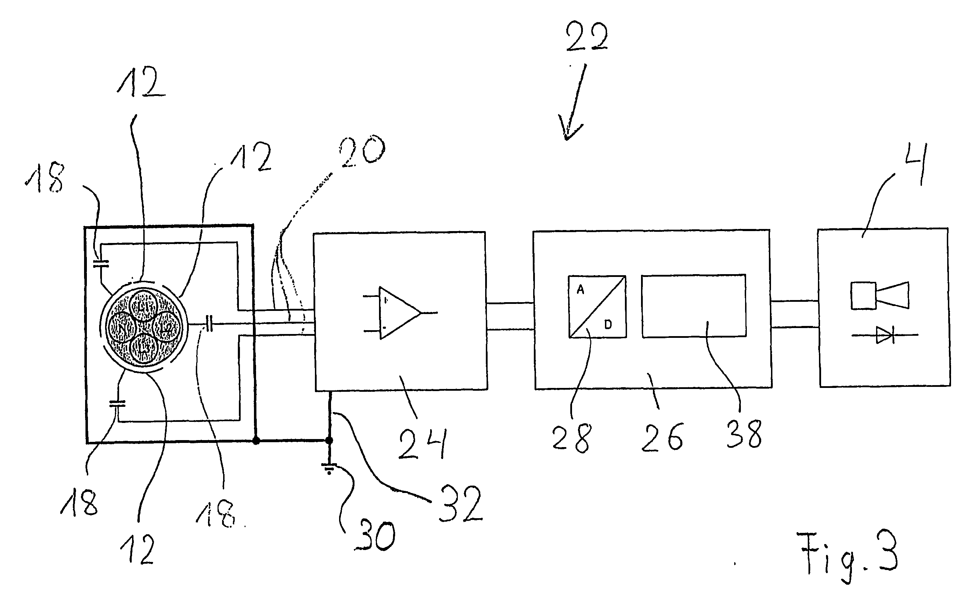

Der Messkopf 10 weist einen Vorsprung 16 auf, der in eine zugehörige, nicht näher bezeichnete Aufnahmeöffnung innerhalb des Gehäuses 2 einsteckbar ist. Hierbei sind die Elektroden 12 des Messkopfes 10 über jeweilige, in Fig. 3 gezeigte Kondensatoren 18 und zugehörige Verbindungsleitungen 20 mit einer elektronischen Mess- und Auswerteinrichtung 22 verbunden, die im Inneren des Gehäuses 2 angeordnet ist.

Die elektronische Mess- uns Auswerteinrichtung 22 umfasst eine Signal-Verstärkungseinheit 24, die in vielfacher Form und Ausführung aus dem Stand der Technik bekannt ist, und die beispielsweise einen in Fig. 3 symbolisch dargestellten Operationsverstärker enthalten kann, der die in die Kondensatoren 18 über die Messelektroden 12 eingekoppelten Signale verstärkt und an eine Auswerteinheit 26 weiterleitet, die vorzugsweise einen Analog/Digital-Wandler 28 enthält, welcher die von der Signalverstärkungs-Einheit 24 verstärkten analogen Signale in digitale Signale wandelt.

Gemäß der Darstellung von Fig. 3 werden die beim Anliegen einer Spannung an einer der Phasen L1, L2 oder L3 in den Messelektroden 12 induzierten oder influenzierten Signale der Signal-Verstärkungs-Einheit 24 in Form von Spannungssignalen zugeführt, deren Größe sich - bezogen auf die Bezugserde 30 - in Abhängigkeit von der Lage der Elektroden 12 relativ zu den Phasen L1, L2 und L3 ergibt.

Hierbei kann es von Vorteil sein, wenn die elektronische Mess- und Auswerteinrichtung 22, oder genauer gesagt die Signal-Verstärkungs-Einheit 24, über eine Verbindungsleitung 32 mit einem in Fig. 1 schematisch dargestellten Erdspieß 34 verbunden wird, der zur Bereitstellung des Erdpotenzials oder der Bezugserde 30 beispielsweise in das Erdreich 36 eingesteckt werden kann.

Die von der Signalverstärkungs-Einheit 24 verstärkten und vom A/D-Wandler 28 digitalisierten Spannungssignale werden vorzugsweise für jede Elektrode 12 getrennt in digitaler Form einem Mikroprozessor 38 in der Auswerteinheit 26 zugeführt, der die Größe der Signale und/oder die Frequenz der Signale sowie auch gegebenenfalls die Phasenlage der Signale bestimmt, und z.B. durch Vergleich miteinander auswertet, und der beim Auftreten einer Signalform, die auf das Anliegen einer Spannung in einer, zwei oder allen drei Phasen L1, L2 und L3 der elektrischen Leitung 6 zurückzuführen ist, ein Alarmsignal erzeugt. Das Alarmsignal kann durch die Anzeigeeinrichtung 4 z.B. mittels eines Lautsprecher in akustischer Form und/oder durch eine Leuchtdiode oder ein LCD-Display oder in sonstiger Weise optisch angezeigt werden, was durch die zugehörigen elektrischen Schaltsymbole in der Anzeigeeinrichtung 4 in Fig. 3 schematisch angedeutet ist.

Gemäß einer weiteren Ausführungsform der Erfindung kann es zusätzlich vorgesehen sein, dass die Flanken der Signale durch den Mikroprozessor 38 ausgewertet werden. Dies bedeutet, dass z.B. der Anstieg der Signale und/oder der Abfall der Signale vom Mikroprozessor 38 vorzugsweise kontinuierlich mit einer hohen zeitlichen Auflösung bestimmt wird, so dass beim Anliegen einer Spannung an einer oder mehrerer der Phasen L1, L2 oder L3 - insbesondere beim Rotieren des Messkopfes um eine in Längsrichtung der elektrischen Leitung 6 verlaufende Achse - entsprechende Signale mit stark ansteigenden oder abfallenden Flanken erzeugt werden, die vom Mikroprozessor 38 zur Bestimmung der Spannungsfreiheit ausgewertet werden.

Hierbei kann es gemäß einer weiteren Ausführungsform der Erfindung von Vorteil sein, wenn die Leitung 6 bei ruhendem Messkopf durch eine weitere Bedienperson, z.B. über Funk, an einem entfernt gelegenen Schaltkasten aus dem spannungsführenden Zustand in den spannungslosen Zustand geschaltet wird, oder umgekehrt, was zu einem sehr steilen Anstieg, oder Abfall der Signalflanken führt, der dann vom Mikroprozessor 38 zur Bestimmung der Spannungsfreiheit herangezogen wird. Für den in der Praxis häufigen Fall, dass am Schaltkasten nicht die zu untersuchende elektrische Leitung, sondern eine andere Leitung geschaltet wird, ergibt sich hierbei keine Änderung der an den Messelektroden erzeugten Signale, so dass die weitere Bedienperson im Schaltkasten entsprechend eine andere in Betracht kommende Leitung wählt.

Bei dieser Ausführungsform der Erfindung kann es in vorteilhafter Weise weiterhin vorgesehen sein, dass der Zeitpunkt der Flankenänderung zusammen mit dem Datum und/oder der Anzahl der Flankenänderungen und/oder gegebenenfalls auch dem Namen oder dem Kürzel des Benutzers durch die erfindungsgemäße Vorrichtung selbständig bestimmt und in der Vorrichtung zu Protokollzwecken gespeichert werden, so dass durch eine anschließende Auswertung der gespeicherten Werte nachvollzogen werden kann, wann und durch wen die Prüfung der Spannungsfreiheit vorgenommen wurde.

Gemäss der Darstellung von Fig. 2 kann der Messkopf 10 eine Abschirmung 40 aufweisen, die den Messkopf bei der Messung vollständig umschließt, um die Messelektroden 12 gegen Störsignale abzuschirmen, die von außen her durch benachbarte Leitungen oder Radiosender etc, eingestrahlt werden. Die Abschirmung 40 ist vorzugsweise über die Verbindungsleitung 32 mit der Bezugserde 30 elektrisch leitend verbunden.

Wie in Fig. 2 weiterhin gezeigt ist, können die Elektroden 12 ebenfalls flächenartig als Ringsegmente ausgestaltet sein, die eine an die Krümmung der Umfangsoberfläche der Leitung 6 angepasste Krümmung aufweisen und die Leitung 6 zu einem Großteil umschließen.

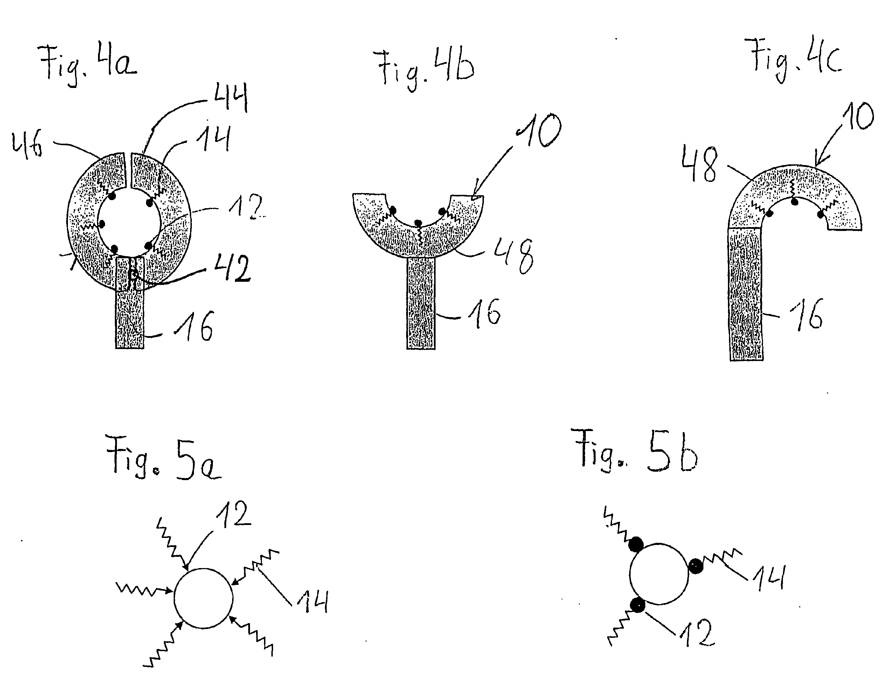

Gemäss der in den Figuren 4a und 5b dargestellten Ausführungsform der Erfindung werden die Elektroden 12 jedoch vorzugsweise durch Rollen oder Kugeln gebildet, die in vorteilhafter Weise drehbar an den zugehörigen federelastischen Elementen 14 befestigt sind. Die federelastischen Elemente 14 sind hierbei vorzugsweise Spiralfedern.

Der Messkopf 10 ist bei dieser Ausführungsform der Erfindung vorzugsweise kreisringförmig ausgestaltet, und weist ein schematisch dargestelltes Scharnier 42 auf, mit Hilfe von welchem die zugehörigen beiden Teilsegmente 44 und 46 aus einer nicht dargestellten geöffneten Stellung in die in Fig. 4a gezeigte geschlossene Stellung verschwenkbar sind.

Gemäss der Darstellung von Fig. 4b und Fig. 4c kann der Messkopf in gleicher Weise teilringförmig ausgestaltet sein, wobei der Teilring 48 gemäss der Darstellung von Fig. 4b entweder zentral am zugehörigen Vorsprung 16, oder aber gemäss der Darstellung von Fig. 4c an einer Stirnfläche eines der Schenkel des Teilrings 48 angeordnet sein kann.

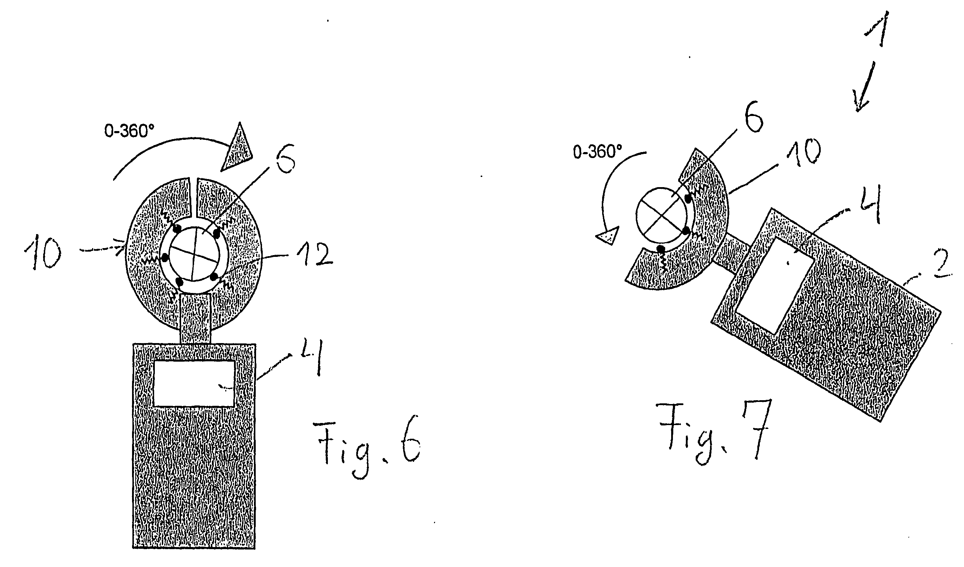

Hierdurch kann beim Einsatz der Ausführungsform von Fig. 4b der Messkopf 10 entsprechend von der Frontseite oder von der Rückseite des Betrachters aus an die elektrische Leitung 6 angelegt werden, wie dies in Fig. 7 gezeigt ist.

Gemäss der Darstellung von Fig. 5a können die Messelektroden 12 als kegelförmige Spitzen ausgestaltet sein, die an den federelastischen Elementen 14 direkt befestigt sind.

Wie der Darstellung von Fig. 6 entnommen werden kann, lässt sich die erfindungsgemäße Vorrichtung 1 bei Einsatz des in Fig. 4a gezeigten kreisringförmigen Messkopfes mit kugelförmigen oder rollenförmigen Elektroden 12 in einem Winkel zwischen 0 und 360° sowie in Gegenrichtung um die nicht näher bezeichnete zentrale Längsachse der elektrischen Leitung 6 drehen, wobei die Messelektroden 12 beim Anliegen einer elektrischen Spannung an einer oder mehrerer der Phasen L1, L2 und L3 aufgrund der sich ändernden elektrischen Feldstärken Spannungssignale erzeugen, die von der elektronischen Mess- und Auswerteinrichtung 22 entsprechend erkannt, und auf der Anzeigeeinrichtung 4 in Form einer Warnmeldung zu optischen und/oder akustischen Anzeige gebracht werden.

In gleicher Weise ist mit dem halbringförmigen Tastkopf 10 gemäss Fig. 7 ebenfalls ein Drehen des Tastkopfes durch Rotieren der erfindungsgemäßen Vorrichtung möglich, wobei die Elektroden 12 in erfindungsgemäßer Weise durch die federelastischen Elemente 14 gegen die Umfangsoberfläche der Außenisolierung 8 gedrängt, und Abweichungen von einer idealen Kreisbewegung beim Rotieren der Vorrichtung durch die Auslenkung der federelastischen Elemente 14 kompensiert werden. Aufgrund der federelastischen Wirkung ist hierbei stets eine zuverlässige Anlage der Elektroden 12 an der Außenisolierung 8 sichergestellt.

### Liste der Bezugszeichen

- 1: Erfindungsgemäße Vorrichtung
- 2: Gehäuse
- 4: Anzeige
- 6: elektrischer Leiter
- 8: Außenisolierung
- 10: Messkopf
- 12: Elektroden
- 14: federelastische Elemente
- 16: Vorsprung am Messkopf
- 18: Kondensatoren
- 20: elektrische Verbindungsleitungen
- 22: elektrische Mess- und Auswerteinrichtung
- 24: Signalverstärkungs-Einheit
- 26: Auswerteinheit
- 28: A/D-Wandler
- 30: Bezugserde
- 32: Verbindungsleitung
- 34: Erdspieß
- 36: Erdreich
- 38: Mikroprozessor
- 40: Abschirmung
- 42: Scharnier
- 44: Teilsegment
- 46: Teilsegment
- 48: Teilring

## Patentansprüche

1. Vorrichtung (1) zur Bestimmung der Spannungsfreiheit einer mit einer Außenisolierung (8) versehenen mehrphasigen elektrischen Leitung (6), insbesondere einer Starkstromleitung mit einer Spannung im Bereich von 400 V, mit einem Gehäuse (2) mit einer darin aufgenommenen elektronischen Mess- und Auswerteinrichtung (22) sowie mit einem Messkopf (10), der mit mindestens drei Messelektroden (12) versehen ist, die mit der elektronischen Mess- und Auswerteinrichtung (22) zur Auswertung der von den Messelektroden (12) erzeugten Signale verbunden sind, wobei die Messelektroden (12) sich über federelastische Elemente (14) am Messkopf (10) abstützen, derart, dass die Messelektroden (12) beim Anlegen des Messkopfes (10) an die Außenisolierung (8) der mehrphasigen elektrischen Leitung (6) mit einer federelastischen Kraft beaufschlagt werden, die die Messelektroden (12) gegen die Außenisolierung (8) drängt.

2. Vorrichtung nach Anspruch 1,
**dadurch gekennzeichnet,dass**
der Messkopf (10) teilringförmig ausgebildet ist, und die Elektroden (12) mit den federelastischen Elementen (14) entlang der Innenumfangsfläche des Messkopfes (10) angeordnet sind.

3. Vorrichtung nach Anspruch 2,
**dadurch gekennzeichnet, dass**
der Teilring (48) als Halbring ausgebildet ist, der sich über einen Winkel von 180° um den Umfang der mehrphasigen elektrischen Leitung (6) herum erstreckt.

4. Vorrichtung nach Anspruch 1,
**dadurch gekennzeichnet, dass**
der Messkopf (10) kreisringförmig ausgebildet ist, und die Elektroden (12) mit den federelastischen Elementen (14) radial zum Zentrum des Messkopfes (10) weisend entlang der Innenumfangsfläche desselben angeordnet sind.

5. Vorrichtung nach Anspruch 4,
**dadurch gekennzeichnet, dass**
der Messkopf (10) zwei oder mehrere Teilsegmente (44, 46) umfasst, die aus einer ersten geschlossenen Stellung, in der die Teilsegmente (44, 46) den Umfang der mehrphasigen elektrischen Leitung (6) vollständig umgreifen, in eine zweite geöffnete Stellung bewegbar sind, in der der Messkopf (10) auf die mehrphasige elektrische Leitung (6) aufgesetzt werden kann.

6. Vorrichtung nach Anspruch 4,
**dadurch gekennzeichnet,dass**
die Teilsegmente (44, 46) durch ein Scharnier (42) aufklappbar miteinander verbunden sind.

7. Vorrichtung nach einem der Ansprüche 4 bis 6,
**dadurch gekennzeichnet,dass**
der Messkopf (10) mit einer elektrisch leitenden Abschirmung (40) versehen ist, die den Messkopf (10) zur Abschirmung der Messelektroden (12) gegen Störsignale radial außenliegend im Wesentlichen vollständig umgibt.

8. Vorrichtung nach einem der vorhergehenden Ansprüche,
**dadurch gekennzeichnet, dass**
die federelastischen Elemente (14) durch Druckfedem gebildet werden.

9. Vorrichtung nach einem der vorhergehenden Ansprüche,
**dadurch gekennzeichnet,dass**
die Messelektroden (10) kugel- oder zylinderförmig ausgestaltet sind.

10. Vorrichtung nach Anspruch 9,
**dadurch gekennzeichnet,dass**
die Messelektroden (10) drehbar an den federelastischen Elementen (14) aufgenommen sind.

11. Vorrichtung nach einem der Ansprüche 1 bis 8,
**dadurch gekennzeichnet,dass**
die Messelektroden (10) kegelförmig ausgebildet sind.

12. Vorrichtung nach einem der Ansprüche 1 bis 8,
**dadurch gekennzeichnet,dass**
die Messelektroden (12) als Platten ausgestaltet sind, die eine der Krümmung der Außenisolierung (8) der mehrphasigen elektrischen Leitung (6) entsprechende Krümmung besitzen.

13. Vorrichtung nach einem der vorhergehenden Ansprüche,
**dadurch gekennzeichnet,dass**
der Messkopf (10) eine ungerade Anzahl von Messelektroden (12) aufweist, die in gleichmäßigen Abständen zueinander am Messkopf (10) angeordnet sind.

14. Vorrichtung nach einem der Ansprüche 1 bis 12,
**dadurch gekennzeichnet,dass**
der Messkopf (10) eine gerade Anzahl von Messelektroden (12) aufweist, die in ungleichmäßigen Abständen zueinander am Messkopf (10) angeordnet sind.

15. Vorrichtung nach einem der vorhergehenden Ansprüche,
**dadurch gekennzeichnet, dass**
der Messkopf (10) vom Gehäuse (2) abnehmbar ausgestaltet ist.

16. Vorrichtung nach einem der vorhergehenden Ansprüche,
**dadurch gekennzeichnet,dass**
die elektronische Mess- und Auswerteinrichtung (22) Mittel (34) aufweist, um die Spannungsdifferenz zwischen einer Bezugserde (30) und einer oder mehrerer der Messelektroden (12) zu bestimmen.

17. Vorrichtung nach Anspruch 16,
**dadurch gekennzeichnet, dass**
die Mittel einen Erdspieß (34) umfassen, der über eine elektrische Verbindungsleitung (32) mit der elektronischen Mess- und Auswerteinrichtung (22) verbindbar ist.

18. Verfahren zur Ermittlung der Spannungsfreiheit einer isolierten mehrphasigen elektrischen Leitung (6), insbesondere einer Starkstromleitung mit einer Spannung im Bereich von 400 V, **gekennzeichnet durch** folgende Verfahrensschritte:
Anlegen eines Messkopfes (10) mit sich daran über federelastische Elemente (14) abstützenden, mit einer elektronischen Mess- und Auswerteinrichtung (22) verbundenen Messelektroden (12) an die Außenisolierung (8) der mehrphasigen elektrischen Leitung (6), in der Weise, dass die Messelektroden (12) **durch** die federelastischen Elemente (14) gegen die Außenisolierung (8) gedrängt werden,
Rotieren des Messkopfes (10) um eine im Wesentlichen entlang des Zentrums der mehrphasigen elektrischen Leitung (6) verlaufende Achse, und
Ermitteln der Änderung der von den Messelektroden (12) erzeugten Signale **durch** die elektronische Mess- und Auswerteinrichtung (22).

19. Verfahren zur Ermittlung der Spannungsfreiheit einer isolierten mehrphasigen elektrischen Leitung (6), insbesondere einer Starkstromleitung mit einer Spannung im Bereich von 400 V, **gekennzeichnet durch** folgende Verfahrensschritte:
Anlegen eines Messkopfes (10) mit sich daran über federelastische Elemente (14) abstützenden, mit einer elektronischen Mess- und Auswerteinrichtung (22) verbundenen Messelektroden (12) an die Außenisolierung (8) der mehrphasigen elektrischen Leitung (6), in der Weise, dass die Messelektroden (12) **durch** die federelastischen Elemente (14) gegen die Außenisolierung (8) gedrängt werden,
Ein- und Ausschalten der elektrischen Spannung an der isolierten mehrphasigen elektrischen Leitung (6), und Ermitteln der Änderung der Flanken der von den Messelektroden (12) erzeugten Signale **durch** die elektronische Mess- und Auswerteinrichtung (22).

20. Verfahren nach Anspruch 19,
**dadurch gekennzeichnet,dass**
der Zeitpunkt und/oder das Datum eines Flankenwechsels und/oder die Anzahl der Flankenwechsel für Protokollzwecke gespeichert werden.

## Claims

1. Device (1) for determining the voltage-free status of a multi-phase cable (6) provided with an outer insulation (8), in particular a power cable having a voltage in the region of 400 V, comprising a housing (2) with an electronic measurement and evaluation device (22) accommodated therein, and comprising a probe head (10) which is provided with at least three measurement electrodes (12) which are connected to the electronic measurement and evaluation device (22) to evaluate the signals generated by the measurement electrodes (12), said measurement electrodes (12) being supported on the probe head (10) via resilient elements (14) such that when the probe head (10) is positioned against the outer insulation (8) of the multi-phase cable (6), the measurement electrodes (12) are subjected to a resilient force which presses them against the outer insulation (8).

2. Device according to claim 1, **characterised in that** the probe head (10) is partly annular and the electrodes (12) are positioned with the resilient elements (14) along the inner circumferential surface of the probe head (10).

3. Device according to claim 2, **characterised in that** the partial ring (48) is provided as a half-ring which extends around the circumference of the multi-phase cable (6) over an angle of 180°.

4. Device according to claim 1, **characterised in that** the probe head (10) is annular and the electrodes (12) are positioned with the resilient elements (14) pointing radially to the centre of the probe head (10) along the inner circumferential surface thereof.

5. Device according to claim 4, **characterised in that** the probe head (10) includes two or more partial segments (44, 46) which may be moved from a first closed position in which they completely encompass the circumference of the multi-phase cable (6), into a second closed position in which the probe head (10) may be positioned onto the multi-phase cable (6).

6. Device according to claim 4, **characterised in that** the partial segments (44, 46) are connected together by a hinge (42) so that they may open out.

7. Device according to any one of claims 4 to 6, **characterised in that** the probe head (10) is provided with an electrically conducting screen (40) which lies radially outside and substantially completely surrounds the probe head (10) in order to screen the measurement electrodes (12) against interference signals.

8. Device according to any one of the preceding claims, **characterised in that** the resilient elements (14) are formed by compression springs.

9. Device according to any one of the preceding claims, **characterised in that** the measurement electrodes (12) are spherical or cylindrical.

10. Device according to claim 9, **characterised in that** the measurement electrodes (12) are accommodated rotatably on the resilient elements (14).

11. Device according to any one of claims 1 to 8, **characterised in that** the measurement electrodes (12) are conical.

12. Device according to any one of claims 1 to 8, **characterised in that** the measurement electrodes (12) are provided as plates which have a curvature corresponding to the curvature of the outer insulation (8) of the multi-phase cable (6).

13. Device according to any one of the preceding claims, **characterised in that** the probe head (10) has an uneven number of measurement electrodes (12) which are positioned at regular intervals to one another on the probe head (10).

14. Device according to any one of claims 1 to 12, **characterised in that** the probe head (10) has an even number of measurement electrodes (12) which are positioned at irregular intervals to one another on the probe head (10).

15. Device according to any one of the preceding claims, **characterised in that** the probe head (10) is provided to be removable from the housing (2).

16. Device according to any one of the preceding claims, **characterised in that** the electronic measurement and evaluation device (22) comprises means (34) to determine the voltage difference between a reference earth (30) and one or more of the measurement electrodes (12).

17. Device according to claim 16, **characterised in that** the means comprise an earth spike (34) which may be connected to the electronic measurement and evaluation device (22) via an electrical connecting linc (32).

18. Method for determining the voltage-free status of an insulated multi-phase cable (6), in particular a power cable having a voltage in the region of 400 V, **characterised by** the following steps: positioning a probe head (10) with measurement electrodes (12) which are connected to an electronic measurement and evaluation device (22) and are supported on the probe head (10) via resilient elements (14), against the outer insulation (8) of the multi-phase cable (6) such that the measurement electrodes (12) are pressed against the outer insulation (8) by the resilient elements (14), rotating the probe head (10) about an axis which extends substantially along the centre of the multi-phase cable (6), and determining the change in the signals, generated by the measurement electrodes (12), by means of the electronic measurement and evaluation device (22).

19. Method for determining the voltage-free status of an insulated multi-phase cable (6), in particular a power cable having a voltage in the region of 400 V, **characterised by** the following steps: positioning a probe head (10) with measurement electrodes (12) which are connected to an electronic measurement and evaluation device (22) and are supported on the probe head (10) via resilient elements (14), against the outer insulation (8) of the multi-phase cable (6) such that the measurement electrodes (12) are pressed against the outer insulation (8) by the resilient elements (14), connecting and disconnecting the electric voltage to the insulated multi-phase cable (6), and determining the change in the edges of the signals generated by the measurement electrodes (12), by means of the electronic measurement and evaluation device (22).

20. Method according to claim 19, **characterised in that** the time and/or the date of an edge change and/or the number of edge changes are stored for logging purposes.

## Revendications

1. Dispositif (1) pour déterminer l'absence de tension sur un conducteur électrique multiphasé (6) doté d'une isolation extérieure (8) et en particulier d'un conducteur pour courant fort dont la tension est d'environ 400 V, avec un boîtier (2) qui contient un dispositif électronique de mesure et d'évaluation (22) et avec une tête de mesure (10) munie d'au moins trois électrodes de mesure (12) qui sont reliées au dispositif électronique de mesure et d'évaluation (22) pour l'évaluation des signaux générés par les électrodes de mesure (12), dans lequel les électrodes de mesure (12) prennent appui sur la tête de mesure (10) par l'intermédiaire d'éléments élastiques (14) de telle sorte que, lorsque l'on pose la tête de mesure (10) sur l'isolation extérieure (8) du conducteur électrique multiphasé (6), les électrodes de mesure (12) sont sollicitées par une force élastique qui force les électrodes de mesure (12) contre l'isolation extérieure (8).

2. Dispositif selon la revendication 1,
**caractérisé en ce que**
la tête de mesure (10) présente une forme d'anneau partiel et **en ce que** les électrodes (12) sont agencées avec les éléments élastiques (14) le long de la surface périphérique intérieure de la tête de mesure (10).

3. Dispositif selon la revendication 2,
**caractérisé en ce que**
l'anneau partiel (48) est configuré comme demi-anneau qui s'étend sur un angle de 180° autour du pourtour du conducteur électrique multiphasé (6).

4. Dispositif selon la revendication 1,
**caractérisé en ce que**
la tête de mesure (10) présente la forme d'un anneau circulaire et **en ce que** les électrodes (12) sont agencées avec les éléments élastiques (14) le long de la surface périphérique intérieure de la tête de mesure (10) de manière à être orientées radialement vers le centre de celle-ci.

5. Dispositif selon la revendication 4,
**caractérisé en ce que**
la tête de mesure (10) présente deux ou plusieurs segments partiels (44, 46) qui peuvent être déplacés entre une première position fermée dans laquelle les segments partiels (44, 46) enserrent complètement le pourtour du conducteur électrique multiphasé (6) et une deuxième position ouverte dans laquelle la tête de mesure (10) peut être posée sur le conducteur électrique multiphasé (6).

6. Dispositif selon la revendication 4,
**caractérisé en ce que**
les segments partiels (44, 46) sont reliés l'un à l'autre de manière pivotante au moyen d'une charnière (42).

7. Dispositif selon l'une des revendications 4 à 6,
**caractérisé en ce que**
la tête de mesure (10) est munie d'un blindage électriquement conducteur (40) qui entoure de manière radialement extérieure et essentiellement complète la tête de mesure (10) pour protéger les électrodes de mesure (12) vis-à-vis de signaux parasites.

8. Dispositif selon l'une des revendications précédentes,
**caractérisé en ce que**
les éléments élastiques (14) sont formés par des ressorts de compression.

9. Dispositif selon l'une des revendications précédentes,
**caractérisé en ce que**
les électrodes de mesure (12) présentent une forme sphérique ou cylindrique.

10. Dispositif selon la revendication 9,
**caractérisé en ce que**
les électrodes de mesure (12) sont montées à rotation sur les éléments élastiques (14).

11. Dispositif selon l'une des revendications 1 à 8,
**caractérisé en ce que**
les électrodes de mesure (12) présentent une forme conique.

12. Dispositif selon l'une des revendications 1 à 8,
**caractérisé en ce que**
les électrodes de mesure (12) présentent la forme de plaques dont la courbure correspond à celle de l'isolation extérieure (8) du conducteur électrique multiphasé (6).

13. Dispositif selon l'une des revendications précédentes,
**caractérisé en ce que**
la tête de mesure (10) présente un nombre impair d'électrodes de mesure (12) agencées à distance régulière les unes des autres sur la tête de mesure (10).

14. Dispositif selon l'une des revendications 1 à 12,
**caractérisé en ce que**
la tête de mesure (10) présente un nombre pair d'électrodes de mesure (12) qui sont agencées à distances irrégulières les unes des autres sur la tête de mesure (10).

15. Dispositif selon l'une des revendications précédentes,
**caractérisé en ce que**
la tête de mesure (10) est configurée de manière à pouvoir être détachée du boîtier (2).

16. Dispositif selon l'une des revendications précédentes,
**caractérisé en ce que**
le dispositif électronique de mesure et d'évaluation (22) présente des moyens (34) pour déterminer la différence de tension entre une mise à la terre de référence (30) et une ou plusieurs des électrodes de mesure (12).

17. Dispositif selon la revendication 16,
**caractérisé en ce que**
les moyens comprennent une perche de mise à la terre (34) qui peut être reliée au dispositif électronique de mesure et d'évaluation (22) au moyen d'un conducteur électrique de liaison (32).

18. Procédé de détermination de l'absence de tension sur un conducteur électrique multiphasé isolé (6) et en particulier sur un conducteur pour courant fort d'une tension d'environ 400 V, **caractérisé par** les étapes suivantes :
poser sur l'isolation extérieure (8) du conducteur électrique multiphasé (6) une tête de mesure (10) sur laquelle des électrodes de mesure (12) reliées à un dispositif électronique de mesure et d'évaluation (22) s'appuient au moyen d'éléments élastiques (14), de telle sorte que les électrodes de mesure (12) sont repoussées contre l'isolation extérieure (8) par les éléments élastiques (14),
tourner la tête de mesure (10) autour d'un axe qui s'étend essentiellement le long du centre du conducteur électrique multiphasé (6) et
au moyen du dispositif électronique de mesure et d'évaluation (22), déterminer la modification des signaux générés par les électrodes de mesure (12).

19. Procédé de détermination de l'absence de tension sur un conducteur électrique multiphasé isolé (6) et en particulier sur un conducteur pour courant fort d'une tension d'environ 400 V, **caractérisé par** les étapes suivantes :
poser sur l'isolation extérieure (8) du conducteur électrique multiphasé (6) une tête de mesure (10) sur laquelle des électrodes de mesure (12) reliées à un dispositif électronique de mesure et d'évaluation (22) s'appuient au moyen d'éléments élastiques (14), de telle sorte que les électrodes de mesure (12) sont repoussées contre l'isolation extérieure (8) par les éléments élastiques (14),
brancher et débrancher la tension électrique sur le conducteur électrique multiphasé isolé (6) et, au moyen du dispositif électronique de mesure et d'évaluation (22), déterminer le changement des flancs des signaux générés par les électrodes de mesure (12).

20. Procédé selon la revendication 19,
**caractérisé en ce que**
l'instant et/ou la date d'un changement de flanc et/ou le nombre de changements de flancs sont conservés à des fins de compte-rendu.
